# EUROPÄISCHE PATENTSCHRIFT

(11) **EP 0 513 534 B1**
(45) Veröffentlichungstag und Bekanntmachung des Hinweises auf die Patenterteilung: **14.08.1996**
(21) Anmeldenummer: 92106386.3
(22) Anmeldetag: 14.04.1992
(51) Int. Cl.: C07F 9/6571, G03C 1/73

(54) **Zyklische Acylphosphinsäurederivate und Verfahren zu ihrer Herstellung**
Cyclic acylphosphinic acid derivatives and process for their preparation
Dérivés cycliques d'acides acylphosphiniques et procédé pour leur préparation

(30) Priorität: 16.05.1991 DE 4115947
(43) Veröffentlichungstag der Anmeldung: 19.11.1992
(73) Patentinhaber: HOECHST AKTIENGESELLSCHAFT, 65926 Frankfurt am Main (DE)
(72) Erfinder: Svara, Jürgen, Dr., W-5000 Köln 50 (DE)

(56) Entgegenhaltungen:
- EP-A- 0 304 782

## Beschreibung

Die Erfindung betrifft neue cyclische Acylphosphinsäurederivate der Formel 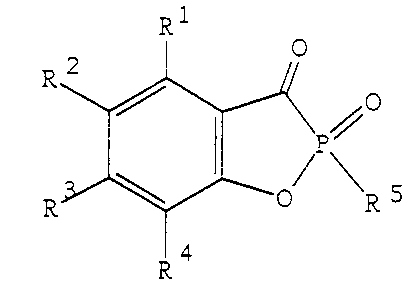
worin die Substituenten unabhängig voneinander folgende Bedeutung haben können:
R¹, R², R³, R⁴ = H, Cl, Br oder C1- bis C10-Alkyl oder -Alkoxy, jedoch mit der Maßgabe, daß entweder R¹ und R² zusammen oder R³ und R⁴ zusammen, unter Einbeziehung des zugehörigen aromatischen 6-Rings, eine Naphthalinstruktur bilden;
R⁵ = C1- bis C4-Alkyl, C5- oder C6-Cycloalkyl, Phenyl oder Alkylphenyl.
Die Substituenten R¹ und R² oder R³ und R⁴ müssen jeweils zusammen eine Benzo-Gruppe bilden, d.h. der vorhandene aromatische Benzolkörper wird zum aromatischen Naphthalinkörper erweitert. Als mögliche Substituenten in diesem erweiterten aromatischen Ringsystem können z.B. eine oder mehrere C1-bis C10-Alkyl- oder -Alkoxygruppen dienen.

Die neuen cyclischen Acylphosphinsäurederivate sind als Photoinitiatoren einsetzbar.

Die Erfindung betrifft weiterhin auch ein Verfahren zur Herstellung der genannten neuen cyclischen Acylphosphinsäurederivate, welches dadurch gekennzeichnet ist, daß man aromatische o-Hydroxycarbonsäuren der Formel 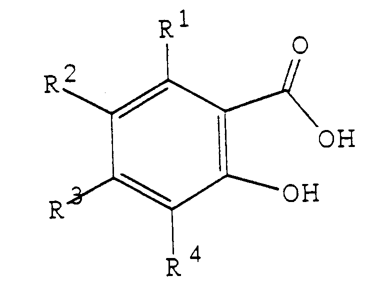
oder deren Alkalimetallsalze mit Organyldichlorphosphanen der Formel R⁵PCl₂, wobei R¹, R², R³, R⁴ und R⁵ die angegebene Bedeutung besitzen, in einem aprotischen Löse- oder Suspendiermittel bei Temperaturen von 0 bis 2oo°C, vorzugsweise 2o bis 15o°C, unter Freisetzung gasförmigen Chlorwasserstoffs bzw. Abscheidung von Alkalichlorid umsetzt und das ausgefallene Zielprodukt abtrennt und in an sich bekannter Weise reinigt.

Aprotische Löse- bzw. Suspendiermittel sind solche, die sich gegenüber einer P-Cl-Gruppe und HCl inert verhalten, z.B. Toluol, Xylol, halogenierte Kohlenwasserstoffe, Petrolether, Alkane, Ether (Methyl-tert.-butylether, Diisopropylether, Glycolether) oder Ether-Ester des Glycols (z.B. Methylglycolacetat). Die einzusetzenden aprotischen Löse- bzw. Suspendiermittel müssen selbstverständlich einen Siedepunkt aufweisen, der oberhalb der gewählten Umsetzungstemperatur liegt oder ihr gerade entspricht.

Als Alkalimetallsalze der einzusetzenden aromatischen o-Hydroxycarbonsäurederivate kommen bevorzugt die Natrium- und Kaliumsalze in Frage.

Die Ausgangsstoffe werden im allgemeinen in stöchiometrischen Gewichtsverhältnissen, d.h. in gleichen molaren Mengen (1 : 1) eingesetzt, doch sind Molverhältnisse von 1 : 2 bis 2 : 1 möglich.

Hinsichtlich der Umsetzungstemperatur wird eine Arbeitsweise unter Rückfluß des Löse- bzw. Suspendiermittels bevorzugt.

Die erfindungsgemäße Umsetzung kann in Gegenwart katalytischer Mengen heterocyclischer, aromatischer Verbindungen oder quartärer Ammonium- oder Phosphoniumsalze durchgeführt werden, welche die Reaktion von P-Cl-Gruppen mit OH-Gruppen beschleunigen. Beispielsweise eignen sich Pyridine, vorzugsweise Dimethylaminopyridine, Chinoline oder Imidazole als Katalysatoren. Im Falle der Verwendung eines Katalysators kann dieser in Mengen von 0,1 bis 1o Mol%, berechnet auf die eingesetzte aromatische o-Hydroxycarbonsäure, zugeführt werden. Im Gegensatz dazu ist die Zugabe eines säurebindenden Mittels, z.B. eines tertiären Amins, in etwa stöchiometrischem Molverhältnis zum Abfangen des Chlorwasserstoffs im Reaktionsgemisch nicht vorteilhaft, da sich in diesem Fall wie erwartet Verbindungen mit 6-Ring-Struktur vom Typus 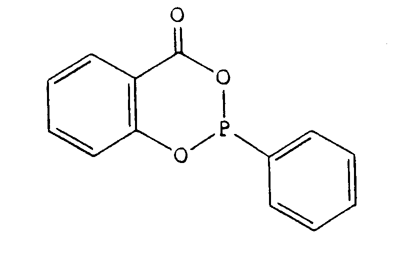
bilden.

Die Umsetzungstemperatur wird in der Regel in Abhängigkeit von der Reaktivität der Einsatzstoffe gewählt. Die Reaktionsdauer ist von untergeordneter Bedeutung und im allgemeinen kürzer, wenn die Umsetzungstemperatur hoch ist. Die Reaktionsdauer kann zwischen 2 und 1oo Stunden liegen.

Die Aufarbeitung der Zielprodukte erfolgt nach Standardmethoden der präparativen organischen Chemie. Häufig sind die Zielprodukte kristallin und werden durch Filtration isoliert, ggf. nach Einengen oder Abkühlen der Reaktionsmischung. Die Kristalle können mit dem aprotischen Lösemittel gewaschen und getrocknet werden. Häufig ist statt des Waschens eine Umkristallisation vorteilhafter.

Beim Einsatz von Alkalisalzen der aromatischen o-Hydroxycarbonsäuren muß das entstehende Alkalimetallchlorid entweder durch Filtration oder durch Waschen des Reaktionsgemischs oder des abgetrennten Rohprodukts mit Wasser entfernt werden.

### Beispiel 1) Umsetzung von 2-Hydroxy-1-naphthoesäure mit Phenyldichlorphosphan PhPCl₂

Zu einer Suspension von 2-Hydroxy-1-naphthoesäure (6,9 g; 36,7 mmol) in iso-Octan (70 ml) tropft man Phenyldichlorphosphan(6,6 g; 36,7 mmol). Beim Erwärmen setzt HCl-Entwicklung ein und der Feststoff verflüssigt sich. Man hält das zweiphasige Reaktionsgemisch 4 h bei 90°C. Beim Abkühlen kristallisiert die untere, zähe, gelbe Schicht durch. Man trennt die überstehende Flüssigkeit ab und kristallisiert den Rückstand aus Toluol um. Das Produkt fällt als gelber, kristalliner Feststoff an.
- Formel:: 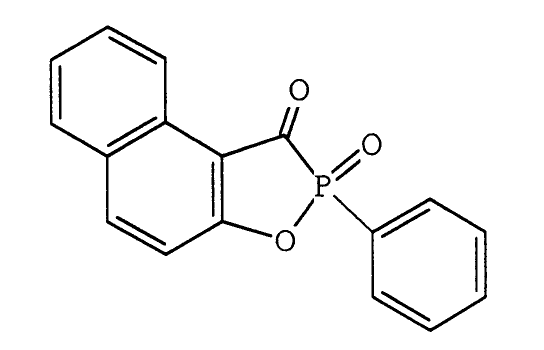
- Name:: 3-Oxo-2-phenyl-naphtho[1,2-d]-1,2-oxaphospholan-2-oxid
- Ausbeute:: 4,1 g (51,6 % d. Th.)
- Schmelzpunkt:: 142-143°C
- NMR-Daten:: ³¹P (CDCl₃ ): 16,9 ppm ;
¹H (80 MHz, CDCl₃): 7,0-9,0 ppm (Multiplett)
¹³C (50 MHz, CDCl₃):
197,9 ppm; Dublett; J(C-P) 111,7 Hz; C=O;
168,4 ppm; Dublett; J(C-P) 2,0 Hz; C-O;
142,8 ppm; Singulett; C-H (Naphtho-);
134,6 ppm; Dublett; J(C-P) 2,96 Hz; C-H (Naphtho-);
132,1 ppm; Dublett; J(C-P) 12,15 Hz; C-H (Phenyl-);
131,5 ppm; Singulett; C-H (Naphtho-);
130,0 ppm; Dublett; J(C-P) 3,07 Hz; C (Naphtho-);
129,3 ppm; Dublett; J(C-P) 13,96 Hz; C-H (Phenyl-);
128,9 ppm; Singulett; C-H (Phenyl-);
128,5 ppm; Dublett J(C-P) 13,05 Hz; C (Naphtho-);
127,0 ppm; Singulett; C-H (Naphtho-);
123,7 ppm; Singulett; C-H (Naphtho-);
123,6 ppm; Dublett; J(C-P) 120,9 Hz; C;
116,0 ppm; Dublett; J(C-P) 73,4 Hz; C;
115,8 ppm; Dublett; J(C-P) 5,1 ppm; C-H (Naphtho)
- MS (Direkteinlaß, 70 eV):: m/e (Iᵣₑₗ, Fragment):
294 (95, M⁺);
266 (100, M-CO 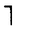 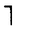 ⁺);
217 (63, M-C₆H₅ 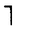 ⁺);
170 (47, M-C₆H₅-PO 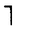 ⁺);
154 (18, M-C₆H₅PO₂ 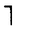 ⁺);
142 (35, M-C₆H₅PO-CO 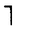 ⁺);
126 (18, C₁₀H₆ 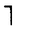 ⁺);
114 (46, C₉H₆ 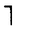 ⁺);
- UV (Acetonitril):: Maxima bei 218, 251 und 339 nm;

### Beispiel 2: Umsetzung von 2-Hydroxy-1-naphthoesäure mit Phenyldichlorphosphan PhPCl₂

Zu einer Suspension von 2-Hydroxy-1-naphthoesäure (91,2 g; 486 mmol) in Xylol/Toluol (300 + 500 ml) tropft man Phenyldichlorphosphan (86,6 g; 486 mmol). Beim Erwärmen setzt HCl-Entwicklung ein und die Lösung färbt sich gelb. Die Naphthoesäure geht unter gleichmäßiger Gasentwicklung langsam in Lösung. Das Reaktionsgemisch wird 88 h bei 117°C gerührt. Beim Abkühlen kristallisiert ein gelber Feststoff aus. Die Kristalle werden abgetrennt, mit Toluol gewaschen und im Vakuum getrocknet.
- Ausbeute:: 58,8 g (41,3 % d. Th.)
- NMR-Daten: ³¹P (CDCl₃ ):: 17,1 ppm (Isomer I);
12,6 ppm (Isomer II);

### Beispiel 3) Umsetzung von 2-Hydroxy-1-naphthoesäure mit Phenyldichlorphosphan PhPCl₂

Die Umsetzung nach Beispiel 1 wird mit 52,7 g (280 mmol) 2-Hydroxy-1-naphthoesäure und 50,1 g (280 mmol) Phenyldichlorphosphan in 250 ml iso-Octan wiederholt, wobei man dem Reaktionsgemisch 110 mg 4-Dimethylaminopyridin zusetzt. Nach einer Reaktionszeit von 4 h bei 95 °C und Umkristallisation aus Toluol erhält man gelbes, kristallines Produkt.
- Ausbeute:: 35 g (42,5 % d. Th.)

### Beispiel 4) Umsetsung von 2-Hydroxy-1-naphthoesäure mit Phenyldichlorphosphan PhPCl₂

Man führt die Reaktion analog Beispiel 1 durch mit 18,1 g (96 mmol) 2-Hydroxy-1-naphthoesäure, 17,1 g (96 mmol) Phenyldichlorphosphan und 110 mg 4-Dimethylaminopyridin in Methylenchlorid (200 ml) während 24 h bei 20 °C, gefolgt von 20 h bei 40°C. Laut P-NMR liegt das cyclische Produkt im Reaktionsgemisch bei vollständiger Umsetzung in einer Reinheit von 91 % vor.

### Beispiel 5) Umsetzung von 2-Hydroxy-1-naphthoesäure mit Methyldichlorphosphan MePCl₂

Zu einer Suspension von 2-Hydroxy-1-naphthoesäure (60 g; 319 mmol) in Toluol (400 ml) gibt man 250 mg 4-Dimethylaminopyridin und tropft dann Methyldichlorphosphan (37,7 g; 319 mmol) zu. Beim Erwärmen setzt HCl-Entwicklung ein und der Feststoff geht langsam in Lösung. Man hält das Reaktionsgemisch 24 h bei 40°C und 7 h bei 100°C. Nach Abdestillieren von 150 ml Lösungsmittel kristallisiert beim Abkühlen ein hellgelber Feststoff aus.
- Formel:: 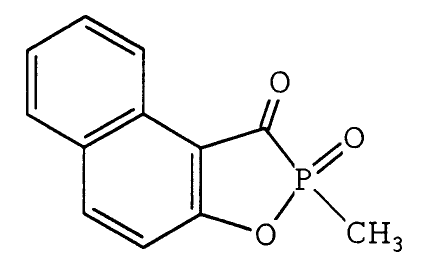
- Name:: 2-Methyl-3-oxo-naphtho[1,2-d]-1,2-oxaphospholan-2-oxid
- Ausbeute:: 23,1 g (31,2 % d. Th.)
- Schmelzpunkt:: 149-152°C
- NMR-Daten:: ³¹P (CDCl₃ ): 29,6 ppm ;
¹³C (24 MHz, CDCl₃/DMSO-d6):
197,6 ppm; Dublett; J(C-P) 106,8 Hz; C=O;
168,4 ppm; Singulett (nicht aufgelöst); C-O;
142,0 ppm; Singulett; C-H (Naphtho-);
130,5 ppm; Singulett; C-H (Naphtho-);
128,1 ppm; Singulett;
126,1 ppm; Singulett;
122,7 ppm; Singulett;
115,8 ppm; Dublett; J(C-P) 4,5 Hz;
115,0 ppm; Dublett; J(C-P) 72,9 Hz;
10,2 ppm; Dublett; J(C-P) 78,2 Hz; CH₃
andere Signale nicht zugeordnet;
- UV (Acetonitril):: Maxima bei 217, 247 und 334 nm;

### Beispiel 6) Umsetzung von 2-Hydroxy-1-naphthoesäure mit Ethyldichlorphosphan EtPCl₂

Wie in Beispiel 5 setzt man 2-Hydroxy-1-naphthoesäure (54,9 g; 292 mmol) in Toluol (400 ml) unter Zugabe von 250 mg 4-Dimethylaminopyridin mit Ethyldichlorphosphan (38,2 g; 292 mmol) um. Man hält das Reaktionsgemisch 24 h bei 40°C und 5 h bei 100°C. Nach Abdestillieren von 200 ml Toluol kristallisiert beim Abkühlen ein hellgelber Feststoff aus.
- Formel:: 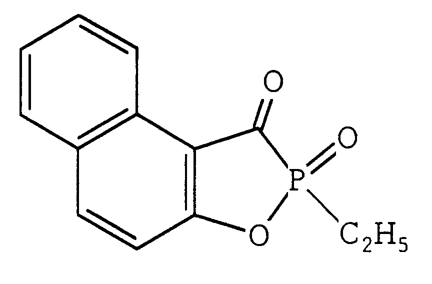
- Name:: 2-Ethyl-3-oxo-naphtho[1,2-d]-1,2-oxaphospholan-2-oxid
- Ausbeute:: 18,2 g (25,3 % d. Th.)
- Schmelzpunkt:: 101-102°C
- NMR-Daten:: ³¹P (CDCl₃ ): 34,1 ppm ;
¹³C (24 MHz, CDCl₃/DMSO-d6):
197,8 ppm; Dublett; J(C-P) 102,0 Hz; C=O;
167,2 ppm; Singulett (nicht aufgelöst); C-O;
142,0 ppm; Singulett; C-H (Naphtho-);
115,5 ppm; Dublett; J(C-P) 67,7 Hz;
115,0 ppm; Dublett; J(C-P) 4,8 Hz;
18,8 ppm; Dublett; J(C-P) 96,8 Hz; CH₂ (Isomer I);
18,1 ppm; Dublett; J(C-P) 75,9 Hz; CH₂ (Isomer II);
4,8 ppm; nicht aufgelöst; CH₃ (Isomer I);
4,2 ppm; Dublett; J(C-P) 4,5 Hz; CH₃ (Isomer II);
andere Signale nicht zugeordnet;
- UV (Acetonitril):: Maxima bei 217, 248 und 334 nm;

### Beispiel 7: Umsetzung von 1-Hydroxy-2-naphthoesäure mit Phenyldichlorphosphan PhPCl₂

Zu einer Suspension von 1-Hydroxy-2-naphthoesäure (59,3 g; 315 mmol) in Xylol (250 ml) tropft man Phenyldichlorphosphan (56,3 g; 315 mmol). Beim Erwärmen setzt HCl-Entwicklung ein und die Lösung färbt sich gelb. Das Reaktionsgemisch wird 10 h bei 110°C und 14 h bei 25°C h gerührt. Danach werden 150 ml Lösungsmittel im Stickstoffstrom abdestilliert (T = 120°C). Beim Abkühlen kristallisiert ein gelber Feststoff aus.
- Formel:: 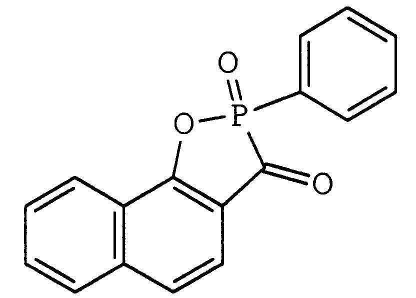
- Name:: 3-Oxo-2-phenyl-naphtho[2,1-d]-1,2-oxaphospholan-2-oxid
- Ausbeute:: 33,7 g (36,4 % d. Th.)
- Schmelzpunkt:: 124-126°C
- NMR-Daten: ³¹P (CDCl₃/DMSO-d6):: 17,9 ppm (Isomer I);
13,5 ppm (Isomer II);
- UV (Acetonitril):: Maxima bei 217, 248, 267, 296 und 318 nm;

## Patentansprüche (Patentansprüche für folgende(n) Vertragsstaat(en): AT, BE, CH, DE, FR, GB, IT, LI, NL)

1. Cyclische Acylphosphinsäurederivate der Formel 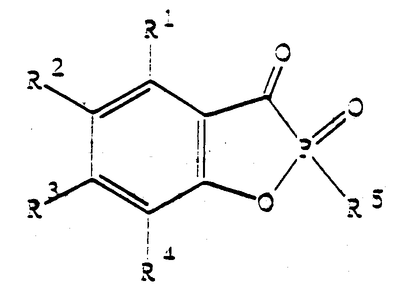 worin die Substituenten unabhängig voneinander folgende Bedeutung haben:
R¹, R², R³, R⁴ = H, Cl, Br oder C1- bis C10-Alkyl oder -Alkoxy, jedoch mit der Maßgabe, daß entweder R¹ und R² zusammen oder R³ und R⁴ zusammen, unter Einbeziehung des zugehörigen aromatischen 6-Rings, eine Naphthalinstruktur bilden;
R⁵ = C1- bis C4-Alkyl, C5- oder C6-Cycloalkyl, Phenyl oder Alkylphenyl.

2. Cyclische Acylphosphinsäurederivate der Formel gemäß Anspruch 1, dadurch gekennzeichnet, daß die Naphthalinstruktur durch eine oder mehrere C1- bis C10-Alkyl- oder -Alkoxygruppen substituiert ist.

3. Verfahren zur Herstellung der cyclischen Acylphosphinsäurederivate gemäß Anspruch 1 oder 2, dadurch gekennzeichnet, daß man aromatische o-Hydroxycarbonsäuren der Formel 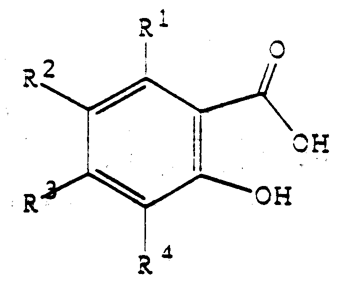 oder deren Alkalimetallsalze mit Organyldichlorphosphanen der Formel R⁵PCl₂, wobei R¹, R², R³, R⁴ und R⁵ die angegebene Bedeutung besitzen, in einem aprotischen Löse- oder Suspendiermittel bei Temperaturen von 0 bis 2oo°C, vorzugsweise 2o bis 15o°C, unter Freisetzung gasförmigen Chlorwasserstoffs bzw. Abscheidung von Alkalichlorid umsetzt und das ausgefallene Zielprodukt abtrennt und in an sich bekannter Weise reinigt.

4. Verfahren gemäß Anspruch 3, dadurch gekennzeichnet, daß man die Umsetzung in Gegenwart katalytischer Mengen heterocyclischer, aromatischer Verbindungen oder quartärer Ammonium- oder Phosphoniumsalze durchführt.

## Patentansprüche (Patentansprüche für folgende(n) Vertragsstaat(en): ES)

1. Verfahren zur Herstellung cyclischer Acylphosphinsäurederivate der Formel 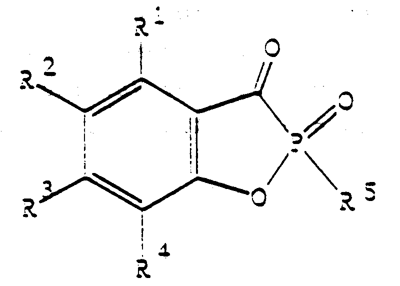 worin die Substituenten unabhängig voneinander folgende Bedeutung haben:
R¹, R², R³, R⁴ = H, Cl, Br oder C1- bis C10-Alkyl oder -Alkoxy, jedoch mit der Maßgabe, daß entweder R¹ und R² zusammen oder R³ und R⁴ zusammen, unter Einbeziehung des zugehörigen aromatischen 6-Rings, eine Naphthalinstruktur bilden, die auch durch eine oder mehrere C1- bis C10-Alkyl- oder -Alkoxygruppen substituiert sein kann;
R⁵ = C1- bis C4-Alkyl, C5- oder C6-Cycloalkyl, Phenyl oder Alkylphenyl; dadurch gekennzeichnet, daß man aromatische o-Hydroxycarbonsäuren der Formel 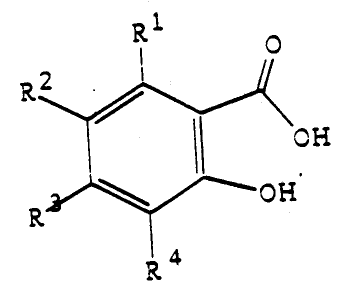 oder deren Alkalimetallsalze mit Organyldichlorphosphanen der Formel R⁵PCl₂, wobei R¹, R², R³, R⁴ und R⁵ die angegebene Bedeutung besitzen, in einem aprotischen Löse- oder Suspendiermittel bei Temperaturen von 0 bis 2oo °C, vorzugsweise 2o bis 15o °C, unter Freisetzung gasförmigen Chlorwasserstoffs bzw. Abscheidung von Alkalichlorid umsetzt und das ausgefallene Zielprodukt abtrennt und in an sich bekannter Weise reinigt.

2. Verfahren gemäß Anspruch 1, dadurch gekennzeichnet, daß man die Umsetzung in Gegenwart katalytischer Mengen heterocyclischer, aromatischer Verbindungen oder quartärer Ammonium- oder Phosphoniumsalze durchführt.

## Claims (Claims for the following Contracting State(s): AT, BE, CH, DE, FR, GB, IT, LI, NL)

1. A cyclic acylphosphinic acid derivative of the formula 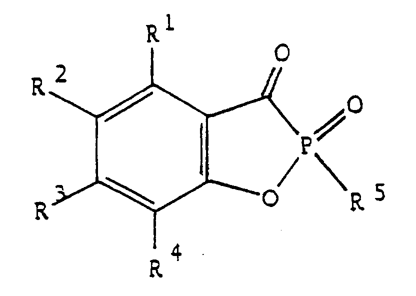 in which the substituents independently of each other have the following meaning:
R¹, R², R³, R⁴ = H, Cl, Br or C1- to C10-alkyl or -alkoxy, but with the proviso that either R¹ and R² together, or R³ and R⁴ together, with incorporation of the associated aromatic 6-ring, form a naphthalene structure;
R⁵ = C1- to C4-alkyl, C5- or C6-cycloalkyl, phenyl or alkylphenyl.

2. The cyclic acylphosphinic acid derivative of the formula as claimed in claim 1, wherein the naphthalene structure is substituted by one or more C1-to C10-alkyl or -alkoxy groups.

3. A process for the preparation of the cyclic acylphosphinic acid derivative as claimed in claim 1 or 2, which comprises reacting an aromatic o-hydroxycarboxylic acid of the formula 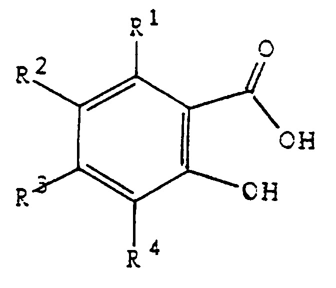 or an alkali metal salt thereof with an organyldichlorophosphine of the formula R⁵PCl₂, where R¹, R², R³, R⁴ and R⁵ have the meaning given, in an aprotic solvent or suspension medium at temperatures of 0 to 200°C, preferably 20 to 150°C, with liberation of gaseous hydrogen chloride or precipitation of alkali metal chloride, and separating off and purifying, in a manner known per se, the precipitated target product.

4. The process as claimed in claim 3, wherein the reaction is carried out in the presence of catalytic quantities of heterocyclic, aromatic compounds or quaternary ammonium salts or phosphonium salts.

## Claims (Claims for the following Contracting State(s): ES)

1. A process for the preparation of a cyclic acylphosphinic acid derivative of the formula 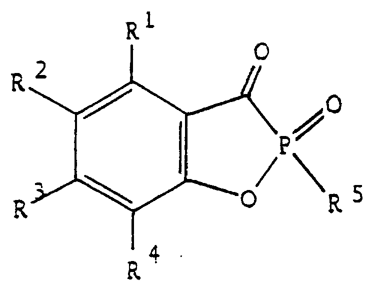 in which the substituents independently of each other have the following meaning:
R¹, R², R³, R⁴ = H, Cl, Br or C1- to C10-alkyl or -alkoxy, but with the proviso that either R¹ and R² together, or R³ and R⁴ together, with incorporation of the associated aromatic 6-ring, form a naphthalene structure which can also be substituted by one or more C1- to C10-alkyl or -alkoxy groups;
R⁵ = C1- to C4-alkyl, C5- or C6-cycloalkyl, phenyl or alkylphenyl; which comprises reacting an aromatic o-hydroxycarboxylic acid of the formula 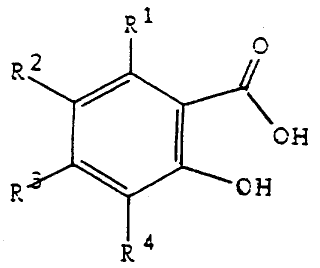 or an alkali metal salt thereof with an organyldichlorophosphine of the formula R⁵PCl₂, where R¹, R², R³, R⁴ and R⁵ have the meaning given, in an aprotic solvent or suspension medium at temperatures of 0 to 200°C, preferably 20 to 150°C, with liberation of gaseous hydrogen chloride or precipitation of alkali metal chloride, and separating off and purifying, in a manner known per se, the precipitated target product.

2. The process as claimed in claim 1, wherein the reaction is carried out in the presence of catalytic quantities of heterocyclic, aromatic compounds or quaternary ammonium salts or phosphonium salts.

## Revendications (Revendications pour l'(les) Etat(s) contractant(s) suivant(s): AT, BE, CH, DE, FR, GB, IT, LI, NL)

1. Dérivés d'acides acylphosphiniques cycliques de formule : 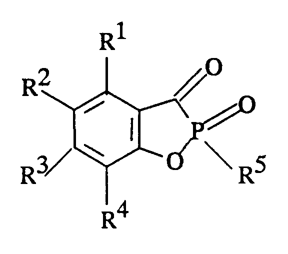 dans laquelle les symboles ont, indépendamment les uns des autres, les significations suivantes :
R¹, R², R³, R⁴ = H, Cl, Br ou alkyle ou alcoxy en C₁-C₁₀, sous réserve cependant que R¹ et R² ensemble, d'une part, ou R³ et R⁴ ensemble, d'autre part, peuvent former, avec le noyau aromatique à six chaînons, une structure naphtalénique ;
R⁵ = alkyle en C₁-C₄, cycloalkyle en C₅ ou C₆, phényle ou alkylphényle.

2. Dérivés d'acides acylphosphiniques cycliques répondant à la formule de la revendication 1, caractérisés en ce que la structure naphtalénique porte un ou plusieurs substituants alkyle ou alcoxy en C₁-C₁₀.

3. Procédé de préparation des dérivés d'acides acylphosphiniques cycliques selon revendication 1 ou 2, caractérisé en ce que l'on fait réagir des acides o-hydroxycarboxyliques aromatiques de formule : 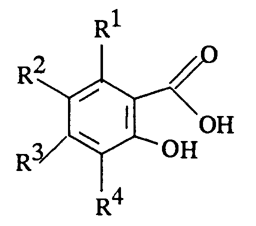 ou leurs sels de métaux alcalins, avec des organyldichlorophosphanes de formule R⁵PCl₂ dans laquelle R¹, R², R³, R⁴ et R⁵ ont les significations indiquées ci-dessus, dans un solvant ou milieu de suspension aprotonique, à des températures de 0 à 200°C, de préférence de 20 à 150°C, avec libération de chlorure d'hydrogène gazeux ou séparation d'un chlorure alcalin, on sépare le produit recherché qui a précipité et on le purifie de manière connue en soi.

4. Procédé selon revendication 3, caractérisé en ce que la réaction est effectuée en présence de quantités catalytiques de composés hétérocycliques aromatiques ou de sels d'ammonium ou de phosphonium quaternaire.

## Revendications (Revendications pour l'(les) Etat(s) contractant(s) suivant(s): ES)

1. Procédé de préparation des dérivés d'acides acylphosphiniques cycliques de formule 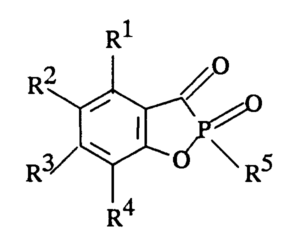 dans laquelle les symboles ont chacun, indépendamment les uns des autres, les significations suivantes :
R¹, R², R³, R⁴ = H, Cl, Br ou alkyle ou alcoxy en C₁-C₁₀ sous réserve que R¹ et R² ensemble, d'une part, ou R³ et R⁴ ensemble, d'autre part, peuvent former avec le cycle aromatique à six chaînons une structure naphtalénique qui peut porter un ou plusieurs substituants alkyle en C₁-C₁₀ ou alcoxy en C₁-C₁₀ ;
R⁵ = alkyle en C₁-C₄, cycloalkyle en C₅ ou C₆, phényle ou alkylphényle ; caractérisé en ce que l'on fait réagir des acides o-hydroxycarboxyliques aromatiques de formule 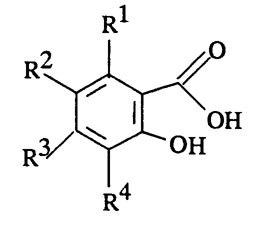 ou leurs sels de métaux alcalins avec des organyldichlorophosphanes de formule R⁵PCl₂, dans laquelle R¹, R², R³, R⁴ et R⁵ ont les significations indiquées ci-dessus, dans un solvant ou milieu de suspension aprotonique, à des températures de 0 à 200°C, de préférence de 20 à 150°C, avec libération de chlorure d'hydrogène gazeux ou séparation d'un chlorure alcalin, on sépare le produit recherché qui a précipité et on le purifie de manière connue en soi.

2. Procédé selon revendication 1, caractérisé en ce que l'on effectue la réaction en présence de quantités catalytiques de composés hétérocycliques aromatiques ou de sels d'ammonium ou de phosphonium quaternaire.
